# EUROPEAN PATENT APPLICATION

(11) **EP 2 523 345 A2**
(43) Date of publication of application: **14.11.2012**
(21) Application number: 12166082.3
(22) Date of filing: 27.04.2012
(51) Int. Cl.: H03F 3/21

(54) **Apparatus and methods for high voltage amplification with low noise**

(30) Priority: 10.05.2011 US 201113104182
(71) Applicant: Honeywell International Inc., Morristown, NJ 07962-2245 (US)
(72) Inventor: Bauhahn, Paul E., Morristown, NJ New Jersey 07962-2245 (US)
(74) Representative: Houghton, Mark Phillip

(57) **Abstract**

Apparatus and methods for high voltage amplification with low noise are provided. In one implementation, a high voltage low noise amplification apparatus includes a low noise broadband amplification circuit configured to amplify a first component of an input signal, the first component comprising a first subset of frequencies; an output isolator configured to create an isolated signal, the isolated signal being the input signal referenced against a broadband output of the low noise broadband amplification circuit; a low frequency amplification circuit configured to amplify a second component of the signal, the second component comprising a second subset of frequencies, wherein the second subset of frequencies is lower than the first subset; and a combination circuit configured to combine the broadband output with a low frequency output of the low frequency amplification circuit.

## Description

### BACKGROUND

Some electrical applications require high voltage ranges to operate correctly. For example, applications that drive piezoelectric actuators use precise high voltages to accurately control the movement of the piezoelectric actuators. However, noise in the control signal of the piezoelectric actuator can render the actuator inoperable for an intended purpose. To achieve the high voltages needed in applications that need a high voltage, low noise signal, a small voltage signal may be amplified to provide a voltage signal in the hundreds of volts. However, the breakdown voltage of typical active devices limits the output voltage range of low noise amplifiers. Further, other methods of amplification develop too much noise and can render the application inoperable. For example, an AC signal can be rectified and stepped up to provide a high voltage. However, a high voltage signal produced through rectification is typically too noisy to provide a precise high voltage to accurately drive applications like a piezoelectric actuator.

### SUMMARY

Apparatus and methods for high voltage amplification with low noise are provided. In one implementation, a high voltage low noise amplification apparatus includes a low noise broadband amplification circuit configured to amplify a first component of an input signal, the first component comprising a first subset of frequencies; an output isolator configured to create an isolated signal, the isolated signal being the input signal referenced against a broadband output of the low noise broadband amplification circuit; a low frequency amplification circuit configured to amplify a second component of the signal, the second component comprising a second subset of frequencies, wherein the second subset of frequencies is lower than the first subset; and a combination circuit configured to combine the broadband output with a low frequency output of the low frequency amplification circuit.

### BRIEF DESCRIPTION OF DRAWINGS

Understanding that the drawings depict only exemplary embodiments and are not therefore to be considered limiting in scope, the exemplary embodiments will be described with additional specificity and detail through the use of the accompanying drawings, in which:

Figure 1 is a block diagram of one embodiment of an apparatus for providing high voltage amplification with a low noise programmable output offset.

Figure 2 is a block diagram illustrating one embodiment of a schematic of an apparatus for providing high voltage amplification with a low noise programmable output offset.

Figure 3 is a block diagram illustrating one embodiment of a schematic of an apparatus driving a piezoelectric actuator.

Figure 4 is a flow diagram of one embodiment of a method for producing a high voltage low noise signal.

In accordance with common practice, the various described features are not drawn to scale but are drawn to emphasize specific features relevant to the exemplary embodiments.

### DETAILED DESCRIPTION

In the following detailed description, references are made to the accompanying drawings that form a part hereof, and in which is shown by way of illustration specific illustrative embodiments. However, it is to be understood that other embodiments may be utilized and that logical, mechanical, and electrical changes may be made. Furthermore, the method presented in the drawing figures and the specification is not to be construed as limiting the order in which the individual acts may be performed. The following detailed description is, therefore, not to be taken in a limiting sense.

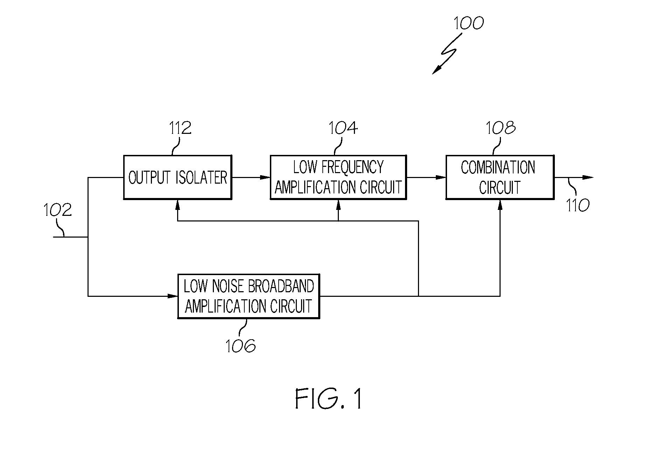

Figure 1 is a block diagram of an amplification apparatus 100 for providing high voltage amplification with a low noise programmable output offset. Amplification apparatus 100 receives an input signal 102, which provides an input voltage to amplification apparatus 100. In some implementations, input signal 102 is a control voltage that connects amplification apparatus 100 to a loop. In some implementations, amplification apparatus 100 receives input signal 102 and amplifies it to provide a high voltage for further connected devices. For example, input signal 102 provides an input voltage between 0 and 10 volts. Amplification apparatus 100 amplifies the input voltage to provide an output signal 110 with a voltage of several hundred volts to drive a high voltage application. The term "high voltage," as used herein, refers to a voltage needed to drive an application. Further, when amplification apparatus 100 amplifies input signal 102, output signal 110 has low noise. The term "low noise," as used herein, refers to noise in a signal does not affect the operation of the high voltage application.

To produce output signal 110, which has a low noise and high voltage, amplification apparatus 100 isolates output signal 110 from input signal 102. To isolate the output signal 110, input signal 102 is received at both an output isolator 112 and a low noise broadband amplification circuit 106. Low noise broadband amplification circuit 106 receives input signal 102 and derives a high frequency component of input signal 102, the high frequency component includes the components of input signal 102 that are greater than a threshold frequency. For example, the threshold frequency can be one Hz. To acquire the high frequency component of input signal 102, input signal 102 passes through a high pass filter in low noise broadband amplification circuit. When low noise broadband amplification circuit 106 isolates the high frequency component of input signal 102, the high frequency component is amplified such that the signal transmitted from low noise broadband amplification circuit 106 is an amplified high frequency signal with a low noise.

Output isolator 112 isolates input signal 102 from output signal 110 by receiving the input signal 102, which is referenced against ground and transmitting a re-referenced signal that is the input signal re-referenced against the low noise high frequency signal transmitted from low noise broadband amplification circuit 106. By re-referencing the input signal 102 to the low noise high frequency signal rather than to a common ground or chassis ground, the output signal 110 is isolated from noise that can exist in the common or chassis ground, which provides the original reference voltage for input signal 102. Further, by re-referencing the input signal 102 against the low noise high frequency signal transmitted from low noise broadband amplification circuit 106, the output signal 110 is referenced against a voltage signal that has low noise.

As amplification apparatus 100 amplifies the high frequency component of input signal 102 by passing the input signal 102 through low noise broadband amplification circuit 106, amplification apparatus 100 also amplifies the low frequency component of input signal 102, the low frequency component including the component of input signal 102 that is less than a threshold frequency. To amplify the low frequency component of input signal 102, amplification apparatus 100 sends the re-referenced signal that is output from output isolator 120 through a low frequency amplification circuit 104. Low frequency amplification circuit 104 isolates the low frequency component of the re-referenced signal by filtering out the high frequency component of the re-referenced signal. When the low frequency component is isolated, low frequency amplification circuit 104 amplifies the low frequency component to a high voltage. Further, to keep noise from affecting the signal, the amplified low frequency component is also referenced against the voltage of the low noise high frequency signal. When the low frequency component is amplified, the isolated signal is low pass filtered, such that noise components greater than the threshold frequency fail to affect applications driven by the high voltage of the low frequency component. As such low frequency amplification circuit 104 outputs a low frequency signal with approximately no noise.

When amplification apparatus 100 has isolated and amplified the high frequency component and the low frequency component, amplification apparatus 100 sends both the low noise low frequency signal, transmitted from low frequency amplification circuit 104, and the low noise high frequency signal, transmitted from low noise broadband amplification circuit 106, to a combination circuit 108. Combination circuit 108 combines both the low noise high frequency signal and the low noise low frequency signal to form output signal 110. Therefore output signal 110 is a low noise amplified signal having both the high and low frequency components of input signal 102.

Amplification apparatus 100 produces the low noise high voltage signal by splitting input signal 102 into a low frequency component and a high frequency component and electrically isolating the output signal 110 from the input signal 102. By splitting the signal, amplification apparatus 100 uses circuitry in low frequency amplification circuit 104 that is designed to amplify low frequencies without unduly increasing the noise. Likewise, amplification apparatus 100 uses circuitry in broadband amplification circuit 106 that is designed to amplify high frequencies without increasing the noise. With the two amplified components, combination circuit 108 combines the two amplified signals into output signal 110. By combining the low noise amplified low frequency component and high frequency component, output signal 110 is a low noise, high voltage signal.

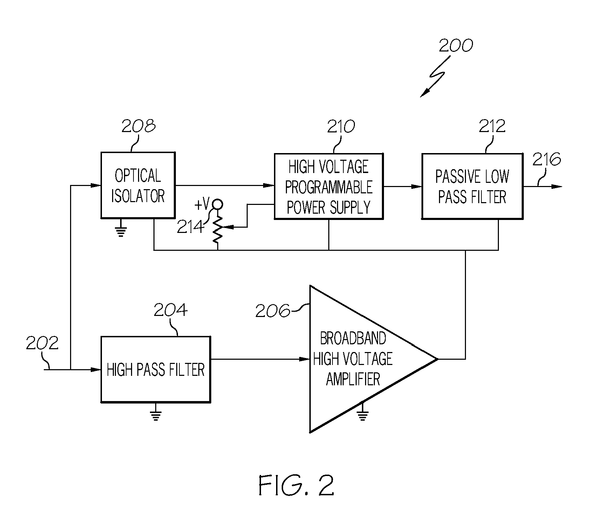

Figure 2 is a block diagram illustrating a schematic of an amplification apparatus 200 for providing high voltage amplification with a low noise programmable output offset. Amplification apparatus 200 receives an input signal 202. Input signal 202 is substantially similar to input signal 102 as described in connection with figure 1. Specifically, input signal 202 has a high frequency component and a low frequency component. As amplification apparatus 200 receives input signal 202, amplification apparatus separates the high frequency and low frequency components of input signal 202 for separate amplification of both the low frequency and high frequency components to create an output signal 216 that represents an amplified input signal 202. Further, amplification apparatus 200 electrically isolates the output signal 216 from input signal 202 and other sources of noise to prevent noise from impacting the ability of the output signal 216 to drive connected devices.

To amplify the high frequency component, input signal 202 is received by a high pass filter 204. High pass filter 204 is configured to allow high frequency components of input signal 202 to pass through while removing the low frequency component of input signal 202. For example, high pass filter 204 filters out signal frequencies that are less than one hertz. High pass filter 204 can be a LRC filter and the like. After high pass filter 204 removes the low frequency component from input signal 202, high pass filter sends the high frequency component to a broadband high voltage amplifier 206. Broadband high voltage amplifier 206 amplifies the high frequency component. In some implementations, Broadband high voltage amplifier 206 is a low noise amplifier designed to amplify a wide range of high frequency electrical signals. Broadband high voltage amplifier 206 introduces relatively little noise into the amplified high frequency component when compared to the voltage gain as broadband high voltage amplifier 206 operates through a linear operative range.

To electrically isolate output signal 216 from input signal 202, Amplification apparatus 202 also receives input signal 202 on optical isolator 208. Optical isolator 208 is an electronic device that transfers electrical signals by utilizing light waves to provide coupling with electrical isolation between the input and output of optical isolator 208. Optical isolator 208 prevents high voltages and rapidly changing voltages from passing from its input to the output. Further, input signal 202, as received by optical isolator 208 is referenced against a common ground or chassis ground. When optical isolator 208 transfers the electrical signal to the output of optical isolator 208, the optical isolator 208 references the output of optical isolator 208 against a voltage source other than the common ground or chassis ground used as a reference for the input of optical isolator 208. By referencing the output of the optical isolator to a different ground than the ground used as a reference for the input signal, the output of optical isolator 208 is electrically isolated from input signal 202. In some implementations, the output of optical isolator 208 is referenced against the low noise high frequency signal from broadband high voltage amplifier 206. By using the low noise high frequency signal from broadband high voltage amplifier 206 as a voltage reference for the output of optical isolator 208, a source with known low noise is used as a reference and noise from ground is prevented from affecting the output of optical isolator 208.

Amplification apparatus 200 uses the output of optical isolator 208 as an input for a high voltage programmable power supply 210. Further, in some implementations, high voltage programmable power supply 210 uses the low noise high frequency signal from broadband high voltage amplifier 206 as a reference voltage. Also, high voltage programmable power supply 210 receives a voltage input from voltage source 214. Voltage source 214 is a device that provides a voltage. For example, in some embodiments, voltage source 214 is a potentiometer coupled to a positive voltage source. High voltage programmable power supply 210 adds the voltages received from optical isolater 208 with the voltage received from voltage source 214 and outputs a high voltage with a low noise. Further, high voltage programmable power supply 210 is unresponsive to rapid changes in input signals. As such, high voltage programmable power supply 210 filters out the high frequency component of the output of optical isolator 208 and isolates the low frequency component of the output of optical isolator 208. As high voltage programmable power supply 210 filters out the high frequency component, the noise that exists in the high frequency bands also is filtered out of the signal. Therefore, high voltage programmable power supply provides a low frequency signal with approximately no noise in the upper frequencies as an output.

As broadband high voltage amplifier 206 provides a low noise high frequency signal and high voltage programmable power supply 210 provides a low frequency signal with negligible noise, Amplification apparatus 200 combines the two signals to produce output signal 216, output signal 216 being a highly amplified, low noise representation of input signal 202. In some implementations, amplification apparatus 200 combines the low noise high frequency signal and the low noise low frequency signal through passive low pass filter 212. Passive low pass filter 212 further filters the low noise low frequency signal and then couples it with the low noise high frequency signal. For example, passive low pass filter 212 can be a low pass RC filter. When passive low pass filter 212 is a low pass RC filter, passive low pass filter 212 further filters frequencies in the high frequency spectrum of the low noise low frequency signal and then capacitatively couples the low noise high frequency signal with the low noise low frequency signal to create output signal 216. Therefore the output signal 216 contains both the amplified low and high frequency components of input signal 202.

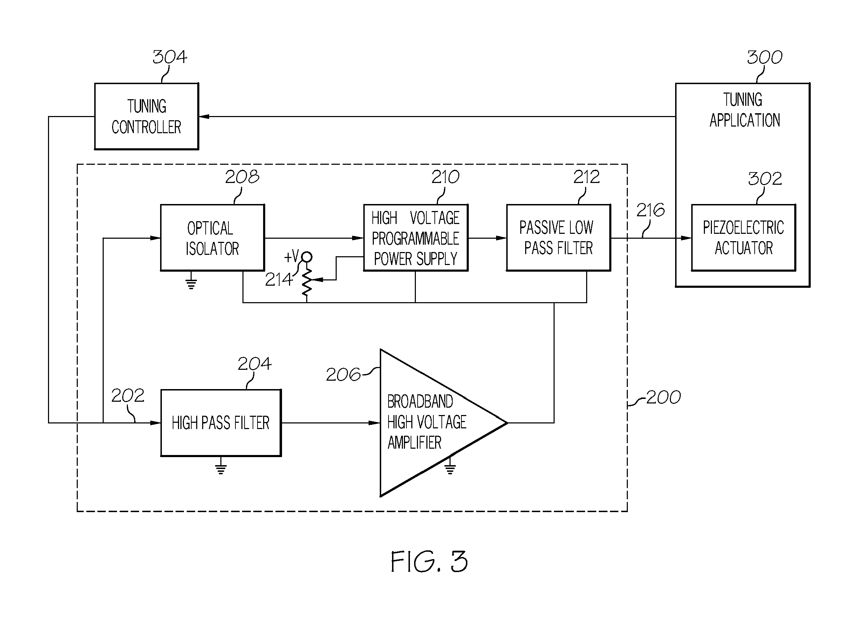

Figure 3 is a block diagram illustrating a schematic of amplification apparatus 200 driving a tuning application 300. In some applications, tuning application 300 is tuned by a piezoelectric actuator 302. For example, in some implementations, tuning application 300 is an optical cavity with a laser that travels between reflective surfaces. Piezoelectric actuator 302 can connect to a reflective surface and be controlled to set the distance that the laser travels within the optical cavity. By controlling the distance within the optical cavity, the amplification apparatus can drive the piezoelectric actuator 302 to set the distance between reflective surfaces in the optical cavity such that the laser resonates within the cavity. In some implementations, a high voltage signal with low noise is needed to accurately drive piezoelectric actuator 302 within an optical cavity. To determine the voltage needed, a tuning controller 304 receives a signal from tuning application 300 indicating whether piezoelectric actuator 302 is at the correct distance. Tuning controller 304 transmits a signal to amplification apparatus 200 that is a driving signal to be amplified to a sufficiently high voltage to capably drive piezoelectric actuator. Amplification apparatus 200 amplifies the voltage and drives the piezoelectric actuator 302 with the amplified voltage, where the amplified voltage is in the hundreds of volts. For example, piezoelectric actuator 302 is made from lead zirconate titanate (PZT). When piezoelectric actuator 302 is made from PZT, amplification apparatus 200 provides an output signal 216 with a magnitude in the hundreds of volts. As amplification apparatus 200 amplifies an input signal 202 received from tuning controller 304 to drive piezoelectric actuator 302, amplification apparatus 200 also limits the amount of noise introduced into the signal. By limiting the noise added during the amplification of input signal 202, output signal 216 provided by amplification apparatus 200 is able to accurately drive piezoelectric actuator 302 in tuning application 300.

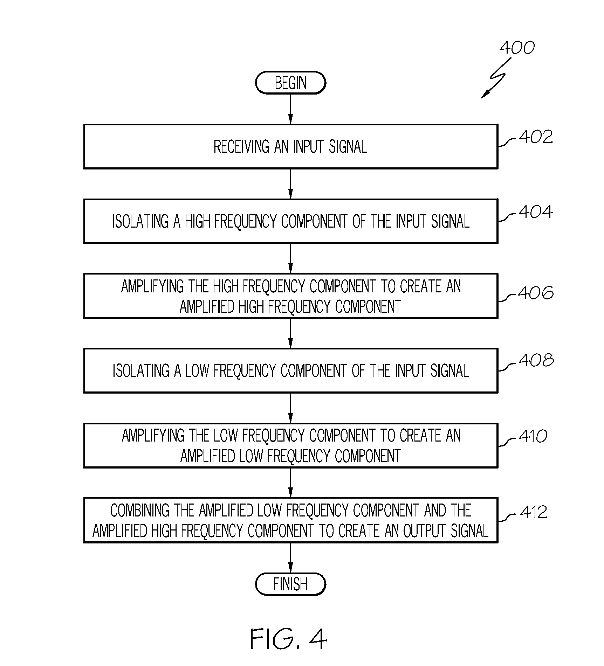

Figure 4 is a flow diagram of a method 400 for producing a high voltage low noise signal. At block 402, an input signal is received. For example, an amplification circuit receives an input signal. At block 404, a high frequency component of the input signal is isolated. For example, the amplification circuit passes the input signal through a high pass filter, the high pass filter removing a low frequency component from the input signal. At block 406, the high frequency component is amplified to create an amplified high frequency component. For instance, the amplification circuit passes the high frequency component of the input signal through a broadband high voltage amplifier.

At block 408, a low frequency component of the isolated input signal is isolated. For example, the isolated input signal is passed through a low pass filter to remove the high frequency portion of the isolated input signal. Alternatively, the isolated input signal is passed into high voltage programmable power supply, where the high frequency portion of the isolated input signal is removed.
At block 410, the low frequency component is amplified to create an amplified low frequency component. For instance, when the isolated input signal is passed into a high voltage programmable power supply, the high voltage programmable power supply amplifies the isolated input signal by using a power supplied on another input of the high voltage programmable power supply in conjunction with the isolated input signal to create the amplified low frequency component. In another example, the low frequency component is amplified by combining the amplified low frequency component with a variable offset voltage and controlling the output of a high voltage power supply with the combined amplified low frequency component and variable offset voltage.

At block 412, the amplified low frequency component and the amplified high frequency component are combined to create an output signal. For example, a low pass filter further filters out high frequency portions of the amplified low frequency component and capacitatively couples the amplified low frequency component with the amplified high frequency component. The amplification circuit then transmits the combined amplified low frequency component and amplified high frequency component as a low noise output signal to drive an application that requires a high voltage but low noise.

### Example Embodiments

Example 1 includes a high voltage low noise amplification apparatus, the apparatus comprising a low noise broadband amplification circuit configured to amplify a first component of an input signal, the first component comprising a first subset of frequencies; an output isolator configured to create an isolated signal, the isolated signal being the input signal referenced against a broadband output of the low noise broadband amplification circuit; a low frequency amplification circuit configured to amplify a second component of the signal, the second component comprising a second subset of frequencies, wherein the second subset of frequencies is lower than the first subset; and a combination circuit configured to combine the broadband output with a low frequency output of the low frequency amplification circuit.

In Example 2, the output isolator of Example 1 can optionally include an optical isolator, the optical isolator electrically isolating an output for the optical isolator from the input signal.

In Example 3, the low frequency amplification circuit of any of Examples 1-2 can optionally include wherein the low frequency amplification circuit comprises a high voltage programmable power supply configured to amplify the low frequency component of the signal.

In Example 4, the high voltage programmable power supply of Example 3 can optionally receive the isolated signal and a positive voltage through a potentiometer as inputs.

In Example 5, the high voltage programmable power supply of any of Examples 3-4 can optionally be referenced against the broadband output.

In Example 6, the broadband amplification circuit of any of Examples 1-5 can optionally include (or comprise) a high pass filter configured to isolate the high frequency component of the input signal by removing the low frequency component of the input signal; and a broadband high voltage amplifier configured to amplify the high frequency component of the signal.

In Example 7, the combination circuit of any of Examples 1-6 can optionally include a low pass filter.

In Example 8, the low pass filter of Example 7 can optionally include (or be) an RC filter and the broadband output is capacitatively coupled to the low frequency output of the RC filter

In Example 9, the amplification apparatus of any of Examples 1-8 can optionally include wherein a combination of the low-frequency output and the broadband output drive a piezoelectric actuator.

In Example 10, the actuator of Example 9 can optionally be a lead zirconate titanate actuator.

Example 11 includes a tuning system, the system comprising an optical cavity, the optical cavity configured to tune a laser travelling therein to a resonant frequency by adjusting a piezoelectric actuator within the optical cavity; a tuning controller configured to receive an adjustment signal from the optical cavity and provide an input signal; and an amplification apparatus configured to amplify the input signal and drive the piezoelectric actuator to cause the laser to resonate within the optical cavity, the amplification apparatus comprising a low noise broadband amplification circuit configured to amplify a first component of the input signal, the first component comprising a first subset of frequencies; an output isolator configured to create an isolated signal, the isolated signal being the input signal referenced against a broadband output of the low noise broadband amplification circuit; a low frequency amplification circuit configured to amplify a second component of the signal, the second component comprising a second subset of frequencies, wherein the second subset of frequencies is lower than the first subset; and a combination circuit configured to combine the broadband output with a low frequency output of the low frequency amplification circuit.

In Example 12, the output isolator of Example 11 can optionally be an optical isolator, the optical isolator electrically isolating the isolated signal from the input signal.

In Example 13, the low frequency amplifier of any of Examples 11-12, can optionally comprise a high voltage programmable power supply configured to amplify the low frequency component of the signal.

In Example 14, the high voltage programmable power supply of Example 13 can optionally receive the isolated signal and a positive voltage through a potentiometer as inputs.

In Example 15, the high voltage programmable power supply of any of Examples 13-14 can optionally be referenced against the broadband output.

In Example 16, the combination circuit of any of Examples 11-15 can optionally be a passive low pass filter.

In Example 17, the passive low pass filter of Example 16 can optionally be a resistor capacitor filter wherein the broadband output is capacitatively coupled to the low-frequency component.

In Example 18, the broadband amplification circuit of any of Examples 11-17 can optionally comprise a high pass filter configured to isolate the high frequency component of the input signal by removing the low frequency component of the input signal; and a broadband high voltage amplifier configured to amplify the high frequency component of the signal.

Example 19 includes a method for providing high-voltage low-noise amplification, the method comprising receiving an input signal; isolating a high frequency component of the input signal, wherein the high frequency component comprises a first subset of frequencies; amplifying the high frequency component to create an amplified high frequency component; isolating a low frequency component of the input signal, wherein the low frequency component is a second subset of frequencies, at least a portion of the second subset of frequencies having a lower frequency than the first subset of frequencies; amplifying the low frequency component to create an amplified low frequency component; and combining the amplified low frequency component and the amplified high frequency component to create an output signal.

In Example 20, the amplifying the low frequency component of Example 19 can optionally include combining the amplified low frequency component with a variable offset voltage; controlling the output of a high voltage power supply with the combined amplified low frequency component and variable offset voltage.

Although specific embodiments have been illustrated and described herein, it will be appreciated by those of ordinary skill in the art that any arrangement, which is calculated to achieve the same purpose, may be substituted for the specific embodiments shown. Therefore, it is manifestly intended that this invention be limited only by the claims and the equivalents thereof.

## Claims

1. A high voltage low noise amplification apparatus (100), the apparatus comprising:
a low noise broadband amplification circuit (106) configured to amplify a first component of an input signal (102), the first component comprising a first subset of frequencies;
an output isolator (112) configured to create an isolated signal, the isolated signal being the input signal (102) referenced against a broadband output of the low noise broadband amplification circuit (106);
a low frequency amplification circuit (104) configured to amplify a second component of the signal, the second component comprising a second subset of frequencies, wherein the second subset of frequencies is lower than the first subset; and
a combination circuit (108) configured to combine the broadband output with a low frequency output of the low frequency amplification circuit (104).

2. The amplification apparatus of claim 1, wherein the output isolator (112) is an optical isolator (208), the optical isolator (208) electrically isolating an output for the optical isolator (208) from the input signal (102).

3. The amplification apparatus of claim 1, wherein the low frequency amplification circuit (104) comprises:
a high voltage programmable power supply (210) configured to amplify the low frequency component of the signal.

4. The amplification apparatus of claim 3, wherein the high voltage programmable power supply (210) receives the isolated signal and a positive voltage through a potentiometer (214) as inputs.

5. The amplification apparatus of claim 3, wherein the high voltage programmable power supply (210) is referenced against the broadband output.

6. The amplification apparatus of claim 1, wherein the broadband amplification circuit comprises:
a high pass filter (204) configured to isolate the high frequency component of the input signal (202) by removing the low frequency component of the input signal (202); and
a broadband high voltage amplifier (206) configured to amplify the high frequency component of the signal.

7. The amplification apparatus of claim 1, wherein the combination circuit includes a low pass filter (212).

8. The amplification apparatus of claim 7, wherein the low pass filter (212) is an RC filter and the broadband output is capacitatively coupled to the low frequency output of the RC filter

9. The amplification apparatus of claim 1, wherein a combination of the low-frequency output and the broadband output drive a piezoelectric actuator (302).

10. A method for providing high-voltage low-noise amplification, the method comprising:
receiving an input signal (102);
isolating a high frequency component of the input signal, wherein the high frequency component comprises a first subset of frequencies;
amplifying the high frequency component to create an amplified high frequency component;
isolating a low frequency component of the input signal (102), wherein the low frequency component is a second subset of frequencies, at least a portion of the second subset of frequencies having a lower frequency than the first subset of frequencies;
amplifying the low frequency component to create an amplified low frequency component; and
combining the amplified low frequency component and the amplified high frequency component to create an output signal (216).
